(19) Europäisches Patentamt
European Patent Office
Office européen des brevets

(11) **EP 2 153 237 B1**

(12) **EUROPÄISCHE PATENTSCHRIFT**

(45) Veröffentlichungstag und Bekanntmachung des Hinweises auf die Patenterteilung:
**30.03.2011 Patentblatt 2011/13**

(21) Anmeldenummer: **08760185.2**

(22) Anmeldetag: **29.05.2008**

(51) Int Cl.:
*G01R 15/18* (2006.01)    *G01R 15/20* (2006.01)

(86) Internationale Anmeldenummer:
**PCT/EP2008/056594**

(87) Internationale Veröffentlichungsnummer:
**WO 2008/145686 (04.12.2008 Gazette 2008/49)**

(54) **ANORDNUNG ZUR MESSUNG EINES IN EINEM ELEKTRISCHEN LEITER FLIESSENDEN STROMS**

ARRANGEMENT FOR MEASURING THE CURRENT RUNNING IN AN ELECTRIC CONDUCTOR

DISPOSITIF DE MESURE D'UN COURANT CIRCULANT DANS UN CONDUCTEUR ÉLECTRIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **01.06.2007 DE 102007025505**

(43) Veröffentlichungstag der Anmeldung:
**17.02.2010 Patentblatt 2010/07**

(73) Patentinhaber: **Epcos AG**
**81669 München (DE)**

(72) Erfinder: **RÖLLGEN, Bernhard**
**81673 München (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
**EP-A- 1 450 166        EP-A- 1 450 176**
**DE-B4-102005 024 075**

**Beschreibung**

Aus der Druckschrift DE 10 2005 024 075 B4 ist eine Vorrichtung zur Messung eines in einem elektrischen Leiter fließenden Stroms bekannt.

Eine zu lösende Aufgabe besteht darin, eine Anordnung zur Messung eines in einem elektrischen Leiter fließenden Stroms anzugeben, welche unabhängig von äußeren magnetischen Einflüssen eine korrekte Messung ermöglicht.

Diese Aufgabe wird durch eine Anordnung zur Messung eines in einem elektrischen Leiter fließenden Stroms gemäß Anspruch 1 gelöst.

Die Anordnung weist einen mit einem Luftspalt versehenen Magnetkreis zur Kopplung mit einem elektrischen Leiter auf. In dem Luftspalt des Magnetkreises ist ein magnetfeldsensitives Bauelement zur Messung des von dem elektrischen Leiter erzeugten Magnetfeldes angeordnet. Im Luftspalt des Magnetkreises können sich zwei Steuerkerne befinden, die jeweils eine Steuerwicklung aufweisen, welche zur Sättigung des jeweiligen Steuerkerns dient.

Durch die Anordnung des magnetfeldsensitiven Bauelements zwischen den Steuerkernen befindet sich das magnetfeld-sensitive Bauelement vorzugsweise in etwa in der Mitte des Luftspalts des Magnetkreises.

In der Nähe des magnetfeldsensitiven Bauelements befinden sich ein oder mehrere zusätzliche Elemente, die unabhängig von den Steuerkernen zur Führung von Magnetfeldern in der Umgebung der Messanordnung durch das magnetfeldsensitive Bauelement geeignet sind.

Magnetfelder in der Umgebung des magnetfeldsensitiven Bauelements, die nicht durch den elektrischen Leiter oder die Steuerwicklungen hervorgerufen werden, können die Messung in erheblichem Ausmaß verschlechtern.

In einer bevorzugten Ausführungsform weist das zusätzliche Element magnetische Eigenschaften auf, um störende externe Magnetfelder auf das magnetfeldsensitive Bauelement zu bündeln.

Bevorzugt weist das zusätzliche Element eine Permeabilitätszahl auf die größer als 1 ist.

Für das zusätzliche Element eignen sich besonders weichmagnetische Materialien, die eine Permeabilitätszahl aufweisen, die größer oder gleich der Permeabilitätszahl der Steuerkerne ist. Dafür geeignet sind vorzugsweise Materialien, die auch für die Steuerkerne Verwendung finden.

Das zusätzliche Element ist bevorzugt beidseitig des magnetfeldsensitiven Bauelements angeordnet, so dass mögliche magnetische Störfelder effektiv in der Nähe des magnetfeldsensitiven Bauelement gebündelt werden können und durch das magnetfeldsensitive Bauelement hindurch geführt werden können.

In einer Ausführungsform ist es auch möglich, dass das Element als ein integraler Bestandteil eines einstückigen Steuerkerns ausgebildet ist. Hierbei ist eine Auswölbung an den Steuerkernen oder eine Verdickung der Steuerkerne in der näheren Umgebung des magnetfeld-sensitiven Bauelements möglich, so dass zwischen den zusätzlichen Elementen und dem magnetfeldsensitiven Bauelement ein möglichst kleiner Luftspalt zustande kommt. Der Bereich der Verdickung oder Auswölbung der Steuerkerne weist auch bei Sättigung der Steuerkerne noch eine Restpermeabilität auf.

In einer weiteren Ausführungsform besteht das Element aus mehreren Einzelteilen, die zu einem Element zusammengefügt werden können.

Bevorzugt weist das zusätzliche Element bei vollständiger Sättigung der Steuerkerne durch die Steuerwicklungen eine Restpermeabilität auf, so dass störende Magnetfelder auch bei Sättigung der Steuerkerne weiterhin von dem zusätzlichen Element gebündelt und durch das magnetfeldsensitive Bauelement geführt werden können.

In einer bevorzugten Ausführungsform besteht das zusätzliche Element aus ferromagnetischem Material, beispielsweise einem Ferrit, einer nanokristallinen Metalllegierung oder aus Permalloy. Es eignen sich jedoch auch andere Materialien, die ferromagnetische Eigenschaften aufweisen.

Um eine zuverlässige Messung des in dem elektrischen Leiter fließenden Stroms zu ermöglichen, ist der Magnetkreis in der Lage, den elektrischen Leiter in seinem Querschnitt vollständig zu umgreifen.

In einer bevorzugten Ausführungsform sind die Steuerkerne als Ferritkerne ausgebildet. Dabei werden die Ferritkerne besonders bevorzugt als rechteckige Rahmen ausgebildet, die auf mindestens einer Seite des Rahmens eine Steuerwicklung zur Sättigung des Ferritkerns aufweisen. In einer besonders effizienten Variante sind Steuerwicklungen auf zwei gegenüberliegenden Seiten des Rahmens angeordnet. Durch die Ausbildung des Steuerkerns in dieser Form kann eine effiziente Sättigung des Steuerkerns erreicht werden.

In einer weiteren Ausführungsform sind die Ferritkerne als Ringe ausgebildet, die in mindestens einem Bereich des Rings eine Steuerwicklung zur Sättigung des Ferritkerns aufweisen. In einer besonders effizienten Variante sind Steuerwicklungen auf zwei gegenüberliegenden Bereichen des Ringes angeordnet, damit eine effiziente Sättigung des Steuerkerns erreicht wird.

In einer bevorzugten Variante sind die Rahmen oder Ringe der jeweiligen Steuerkerne so ausgerichtet, dass die in den jeweiligen Rahmen oder Ringen liegenden Ebenen bevorzugt in einer gemeinsamen Ebene liegen. Durch diese Anordnung, bei der die beiden Steuerkerne in einer Ebene liegen, wird die Überlappfläche der Steuerkerne auf ein Maximum optimiert. Dadurch wird eine Minimierung des Luftspalts erreicht, in dem das magnetfeldsensitive Bauelement angeordnet ist.

In einer weitern Ausführungsform ist es auch möglich, dass die Steuerkerne nicht in einer gemeinsamen Ebene liegen, sondern zueinander längs einer Achse, die durch die beiden Steuerkerne und das magnetfeldsensitive Bauelement führt, verdreht angeordnet sind.

Das magnetfeldsensitive Bauelement ist bevorzugt ein Hall-Sensor. Wird ein Hall-Sensor von einem Strom durchflossen und in ein senkrecht dazu verlaufendes Magnetfeld gebracht, liefert er eine Ausgangsspannung, die proportional zum Produkt aus magnetischer Feldstärke und Strom ist.

Zur Bestimmung des in dem elektrischen Leiter fließenden Stroms werden verschiedene Messungen mit Hilfe des Hallsensors durchgeführt. Eine erste Messung findet bei positiv gesättigten Steuerkernen statt, eine weitere Messung kurz nach dem Abschalten des Stroms der durch die Steuerwicklungen fließt. Eine weitere Messung erfolgt bei negativ gesättigten Steuerkernen, gefolgt von einer Messung kurz nach dem Abschalten des Stroms der durch die Steuerwicklungen fließt. Aus diesen vier Messungen kann, unter Berücksichtigung von bestimmten Faktoren, die sich durch die Sensitivität des Hallsensors bei gesättigten bzw. bei ungesättigten Steuerkernen ergeben, über bekannte Gleichungen die Stromstärke des durch den elektrischen Leiter fließenden Stroms berechnet werden.

Durch die neu hinzugefügten Elemente aus bevorzugt weichmagnetischem Material können störende Einflüsse durch externe Magnetfelder in den Gleichungen sowohl bei gesättigten Steuerkernen als auch bei ungesättigten Steuerkernen eliminiert werden, da diese Beiträge durch die zusätzlichen Elemente aneinander angeglichen werden können.

Die zusätzlichen bevorzugt weichmagnetischen Elemente in der Nähe des Hallsensors ermöglichen eine Angleichung der Beiträge der externen Störmagnetfelder in den Gleichungen zur Berechnung der Stromstärke, so dass diese Beiträge eliminiert werden können. Der Beitrag, der durch störende externe Magnetfelder verursacht wird, wird somit bei Berechnung mit ungesättigten Steuerkernen, als auch bei Berechnung mit gesättigten Steuerkernen angeglichen und kann somit aus den Gleichungen eliminiert werden. Dadurch kann das lineare Gleichungssystem auf einfache Art und Weise gelöst werden und die Stromstärke des elektrischen Leiters ermittelt werden.

Dabei werden folgende zwei Gleichungen aufgestellt:

$$R_L = n + s_l * I + s_{Bl} * B_{static} * \sin(\alpha)$$

$$R_H = n + s_h * I + s_{Bh} * B_{static} * \sin(\alpha)$$

In der Messung werden physikalische Größen oft in analoge elektrische Größen umgewandelt. Bei der Quantisierung wird der Messbereich der analogen Größe in eine endliche Zahl aneinander angrenzende Teilbereiche (Intervalle) aufgeteilt und jedem davon ein Wert eines endlichen symbolischen Systems zugeordnet (z.B. eine ganze Zahl). Als Auflösung wird die Anzahl der verwendeten Teilbereiche der analogen Größe, bei binären symbolischen Systemen auch ihre Zweierpotenz (Auflösung in Bit) bezeichnet, jedoch bei gleich großen Intervallen auch die Größe der Intervalle selbst.

Die Quantisierungsschritte geben den Wert für das Messsignal in diskreter Form wieder.

In den oben aufgeführten Gleichungen gibt $R_L$ die Anzahl der Quantisierungsschritte für die Messung bei geringer Sensitivität an und $R_H$ die Anzahl bei hoher Sensitivität. Die Variable n gibt den Nullpunkt des magnetfeldsensitiven Bauelements in Quantisierungsschritte an. Die Variablen $S_1$ und $S_h$ geben die Sensitivität des magnetfeldsensitiven Elements bei gesättigten Steuerkernen ($S_1$) bzw. bei ungesättigten Steuerkernen ($S_h$) an. Die Variable $B_{static}$ bezeichnet die magnetische Flussdichte eines externen Magnetfeldes, und die Variable $\alpha$ gibt den Winkel, an, aus dem das externe Magnetfeld auf das magnetfeld-sensitive Bauelement trifft. Die Variable I gibt die Stromstärke des stromdurchflossenen Leiters an, die in der Messung ermittelt werden soll.

Die zusätzlichen bevorzugt weichmagnetischen Elemente in der Nähe des magnetfeldsensitiven Bauelements ermöglichen es nun, die Variablen $S_{Bl}$ und $S_{Bh}$ anzugleichen. Dadurch lässt sich das lineare Gleichungssystem zur Bestimmung der Stromstärke I auf einfache Art und Weise lösen.

Die Anordnung wird im Folgenden anhand von Ausführungsbeispielen und den dazugehörigen Figuren näher erläutert.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein.

Elemente, die einander gleichen oder die die gleiche Funktion übernehmen, sind mit gleichen Bezugszeichen bezeichnet.

Figur 1 zeigt eine beispielhafte Anordnung zur Messung eines in einem elektrischen Leiter fließenden Stroms.

Figur 2 zeigt einen Ausschnitt einer beispielhaften Anordnung zur Messung eines in einem elektrischen Leiter fließenden Stroms.

Figur 3 zeigt einen Ausschnitt einer weiteren beispielhaften Anordnung zur Messung eines in einem elektrischen Leiter fließenden Stroms.

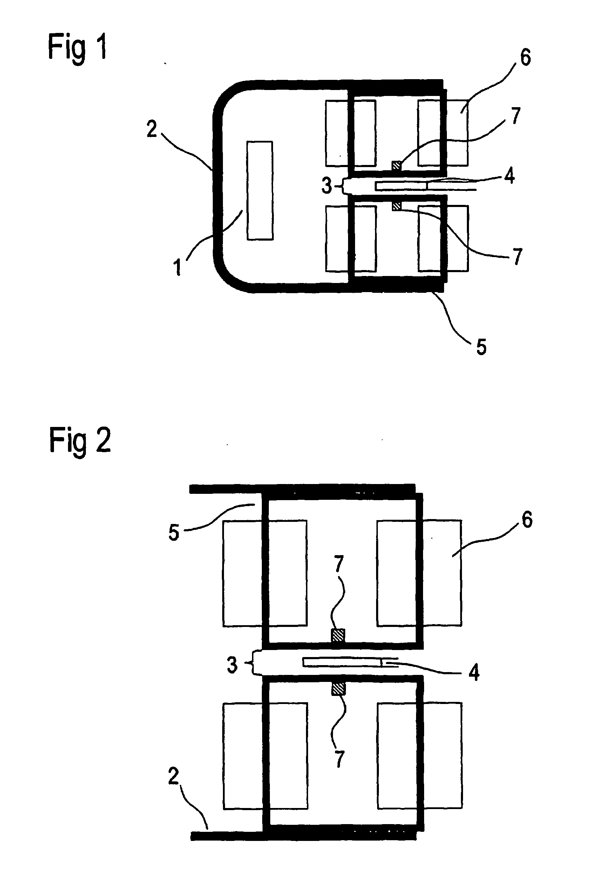

In Figur 1 ist eine mögliche Variante der beispielhaften Anordnung zur Messung eines in einem elektrischen Leiter fließenden Stroms gezeigt, bei der ein Magnetkreis 2 der aus Ferrit bestehen kann einen elektrischen Leiter 1 umgreift. Der Magnetkreis 2 weist auf einer Seite einen Luftspalt 3 auf, in dem sich zwei Steuerkerne 5 befinden. Zwischen den Steuerkernen 5 befindet sich ein magnetfeldsensitives Bauelement 4, das zur Messung des in dem elektrischen Leiter 1 fließenden Stroms dient. Die Steuerkerne 5 weisen jeweils Steuerwicklungen 6 auf, die zur Sättigung der Steuerkerne 5 dienen. Diese Steuerwicklungen 6 befinden sich bevorzugt auf einer oder mehreren, bevorzugt gegenüberliegenden Seiten des Rahmens des Steuerkerns 5.

In einer weiteren Ausführungsform kann es sich bei den Steuerkernen 5 auch um Ringe handeln, die hier nicht dargestellt sind. Diese Ringe weisen in einem oder mehreren Bereichen Steuerwicklungen 6 auf, die bevorzugt in gegenüberliegenden Bereichen angeordnet sind.

Um Störungen bei der Messung des durch den elektrischen Leiter 1 fließenden Stroms auszuschließen bzw. bei der Bestimmung der benötigten Messwerte herauszurechnen, befinden sich in der Nähe des magnetfeldsensitiven Bauelements 4 weitere Elemente 7, die störende Magnetfelder bündeln und durch das magnetfeldsensitive Bauelement 4 leiten.

In einer bevorzugten Ausführungsform sind für diese Elemente 7 bevorzugt weichmagnetische Materialien geeignet. Diese Elemente 7 können sowohl separat, als auch als Teilbereich des Steuerkerns ausgebildet sein. Es ist auch möglich die Elemente 7 aus mehreren Einzelteilen zusammenzusetzen. In einer bevorzugten Ausführungsform bilden die Elemente 7 einen Teil des Steuerkerns 5. In diesem Fall sind besonders Ausbuchtungen oder Verdickungen des Steuerkerns 5 in der Nähe des magnetfeldsensitiven Bauelements 4 geeignet.

Diese Elemente 7 können wie in der bevorzugten Ausführungsform aus dem gleichen Material bestehen wie die Steuerkerne 5. In einer weiteren Ausführungsform können die Elemente 7 jedoch auch als jedem beliebigen Material gebildet sein, das weichmagnetische Eigenschaften aufweist. Die Form des Elements 7 hat hierbei keinen Einfluss auf den Einfluss den das Element 7 auf störende Magnetfelder ausübt.

Das Element 7 kann beispielsweise in Form eines Quadrates, in Form eines Ringes, in Form eines Oktaeders, in Form eines Dodekaeders oder in jeder beliebig anderen Form ausgebildet sein.

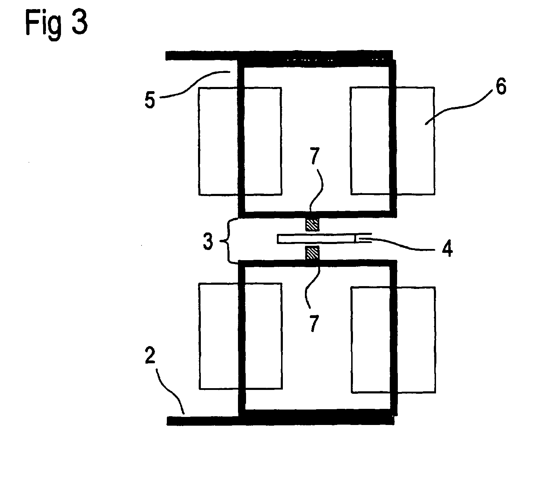

In Figur 2 und Figur 3 ist ein Ausschnitt der Figur 1 gezeigt, der die Positionierung der Elemente 7 im Bereich des magnetfeldsensitiven Bauelements 4 näher darstellen soll. Die exakte Position des Elements 7 ist nicht von großer Bedeutung, es sollte nur gewährleistet sein, dass das Element 7 in der Nähe des magnetfeldsensitiven Bauelements 4 angeordnet ist, damit störende Magnetfelder in der Umgebung der Messanordnung gebündelt werden können und durch das magnetfeldsensitive Bauelement 4 geleitet werden können.

Obwohl in den Ausführungsbeispielen nur eine beschränkte Anzahl möglicher Weiterbildungen der Erfindung beschrieben werden konnte, ist die Erfindung nicht auf diese beschränkt. Es ist prinzipiell möglich, eine andere Anzahl der Steuerwicklungen, eine andere Form des Magnetkreises für die Anordnung zu verwenden oder die Elemente in versetzter Lage zueinander anzuordnen. Die Erfindung ist nicht auf die Anzahl der schematisch dargestellten Elemente beschränkt.

Die Beschreibung der hier angegebenen Gegenstände und Verfahren ist nicht auf die einzelnen speziellen Ausführungsformen beschränkt. Vielmehr können die Merkmale der einzelnen Ausführungsformen - soweit technisch sinnvoll - beliebig miteinander kombiniert werden.

Bezugszeichenliste

1     elektrischer Leiter

2     Magnetkreis

3     Luftspalt

4     Magnetfeldsensitives Bauelement

5    Steuerkern

6    Steuerwicklung

7    Zusätzliches Element


**Patentansprüche**

1.  Anordnung zur Messung eines in einem elektrischen Leiter (1) fließenden Stroms, aufweisend

    - einen Magnetkreis (2) mit Luftspalt (3) zur Kopplung mit dem elektrischen Leiter (1),
    - ein im Luftspalt (3) des Magnetkreises (2) angeordnetes magnetfeldsensitives Bauelement (4) zur Messung des vom elektrischen Leiter (1) erzeugten Magnetfelds,

    **gekennzeichnet durch**

    - zwei Steuerkerne (5) zur Steuerung des Luftspalts (3), die in dem Luftspalt (3) angeordnet sind,
    - wobei die Steuerkerne (5) jeweils eine Steuerwicklung (6) zur magnetischen Sättigung des jeweiligen Steuerkerns (5) aufweisen,
    - wobei das magnetfeldsensitive Bauelement (4) zwischen den Steuerkernen (5) angeordnet ist und sich in der Nähe des magnetfeldsensitiven Bauelements (4) ein oder mehrere zusätzliche Elemente (7) befinden, die unabhängig von den Steuerkernen (5) zur Führung von Magnetfeldern in der Umgebung des magnetfeldsensitiven Bauelements (4) geeignet sind.

2.  Anordnung nach Anspruch 1,
    bei dem die Elemente (7) magnetisierbar sind.

3.  Anordnung nach einem der vorhergehenden Ansprüche,
    bei dem die Elemente (7) aus einem weichmagnetischen Material bestehen.

4.  Anordnung nach einem der vorhergehenden Ansprüche,
    bei dem die Elemente (7) eine Permeabilitätszahl aufweisen,
    die größer oder gleich der Permeabilitätszahl der Steuerkerne (5) ist.

5.  Anordnung nach einem der vorhergehenden Ansprüche,
    bei dem die Elemente (7) zu beiden Seiten des magnetfeldsensitiven Bauelements (4) angeordnet sind.

6.  Anordnung nach einem der vorhergehenden Ansprüche,
    bei dem die Elemente (7) eine Restpermeabilität aufweisen, wenn die Steuerkerne (5) gesättigt sind.

7.  Anordnung nach einem der vorhergehenden Ansprüche,
    bei dem die Elemente (7) ferromagnetische Metalle enthalten.

8.  Anordnung nach einem der vorhergehenden Ansprüche,
    bei dem der Magnetkreis (2) den elektrischen Leiter (1) umgreift.

9.  Anordnung nach einem der vorhergehenden Ansprüche,
    bei dem die Steuerkerne (5) als Ferritkerne ausgebildet sind.

10. Anordnung nach Anspruch 9,
    bei dem die Steuerkerne (5) einen rechteckige Rahmen aufweisen und auf mindestens einer Seite des Rahmens eine Steuerwicklung (6) zur Sättigung des Steuerkerns (5) aufweisen.

11. Anordnung nach Anspruch 9,
    bei dem die Steuerkerne (5) in Form eines Ringes ausgebildet sind und in einem Teilbereich des Ringes eine Steuerwicklung (6) zur Sättigung des Steuerkerns (5) aufweisen.

**12.** Anordnung nach einem der vorhergehenden Ansprüche,
bei dem die Steuerkerne (5) auf zwei gegenüberliegenden Seiten eine Steuerwicklung (6) aufweisen.

**13.** Anordnung nach einem der vorhergehenden Ansprüche,
bei dem die Steuerkerne (5) in einer gemeinsamen Ebene liegen.

**14.** Anordnung nach einem der Ansprüche 1 bis 12,
bei dem die Steuerkernen (5) zueinander verdreht angeordnet sind.

**15.** Anordnung nach einem der vorhergehenden Ansprüche,
bei dem das magnetfeldsensitive Bauelement (4) ein Hall-Sensor ist.

**Claims**

**1.** An arrangement for measuring a current flowing in an electrical conductor (1), comprising

- a magnetic circuit (2) having an air gap (3) for coupling to the electrical conductor (1),
- a component (4) sensitive to magnetic fields disposed in the air gap (3) of the magnetic circuit (2) for measuring the magnetic field generated by the electrical conductor (1), **characterized by**
- two control cores (5) for controlling the air gap (3) and disposed in the air gap (3),
- wherein the control cores (5) each comprise a control coil (6) for magnetically saturating each control core (5),
- wherein the component (4) sensitive to magnetic fields is disposed between the control cores (5) and one or more additional elements (7) are located near the component sensitive to magnetic fields, suitable for guiding magnetic fields independently of the control cores (5) in the environment of the component (4) sensitive to magnetic fields.

**2.** The arrangement according to Claim 1, wherein the elements (7) can be magnetized.

**3.** The arrangement according to one of the preceding claims, wherein the elements (7) are made of a soft magnetic material.

**4.** The arrangement according to one of the preceding claims, wherein the elements (7) comprise a permeability number that is greater than or equal to the permeability number of the control cores (5).

**5.** The arrangement according to one of the preceding claims, wherein the elements (7) are disposed on either side of the component (4) sensitive to magnetic fields.

**6.** The arrangement according to one of the preceding claims, wherein the elements (7) comprise a residual permeability if the control cores (5) are saturated.

**7.** The arrangement according to one of the preceding claims, wherein the elements (7) comprise ferromagnetic metals.

**8.** The arrangement according to one of the preceding claims, wherein the magnetic circuit (2) encompasses the electrical conductor.

**9.** The arrangement according to one of the preceding claims, wherein the control cores (5) are implemented as ferrite cores.

**10.** The arrangement according to Claim 9, wherein the control cores (5) comprise a rectangular frame, and comprise a control winding (6) for saturating the control core (5) on at least one side of the frame

**11.** The arrangement according to Claim 9, wherein the control cores (5) are implemented in the form of a ring, and comprise a control winding (6) for saturating the control core in a partail region of the ring.

**12.** The arrangement according to any of the preceding claims, wherein the control cores (5) comprise a control winding on two opposite sides.

**13.** The arrangement according to one of the preceding claims, wherein the control cores (5) lie in a common plane.

**14.** The arrangement according to one of the Claims 1 through 12, wherein the control cores (5) are arranged rotated relative to each other.

**15.** The arrangement according to one of the preceding claims, wherein the component sensitive to magnet fields (4) is a Hall-effect sensor.


**Revendications**

**1.** Arrangement pour mesurer un courant circulant dans un conducteur électrique (1), comportant

- un circuit magnétique (2) avec un entrefer (3) pour le couplage avec le conducteur électrique (1),
- un composant (4) sensible au champ magnétique et disposé dans l'entrefer (3) du circuit magnétique (2) pour la mesure du champ magnétique généré par le conducteur électrique (1), **caractérisé par**
- deux noyaux de commande (5) pour la commande de l'entrefer (3), qui sont disposés dans l'entrefer (3),
- sachant que les noyaux de commande (5) comportent chacun un enroulement de commande (6) pour la saturation magnétique de chacun des noyaux de commande (5),
- sachant que le composant (4) sensible au champ magnétique est disposé entre les noyaux de commande (5) et qu'un ou plusieurs éléments supplémentaires (7) sont disposés près du composant sensible au champ magnétique (4), lesquels sont appropriés pour guider des champs magnétiques dans le voisinage du composant sensible au champ magnétique (4), indépendamment des noyaux de commande (5).

**2.** Arrangement selon la revendication 1, dans lequel les éléments (7) sont magnétisables.

**3.** Arrangement selon l'une quelconque des revendications précédentes, dans lequel les éléments (7) se composent d'une matière magnétique douce.

**4.** Arrangement selon l'une quelconque des revendications précédentes, dans lequel les éléments (7) présentent une perméabilité relative supérieure ou égale à la perméabilité relative des noyaux de commande (5).

**5.** Arrangement selon l'une quelconque des revendications précédentes, dans lequel les éléments (7) sont disposés sur les deux côtés du composant sensible au champ magnétique (4).

**6.** Arrangement selon l'une quelconque des revendications précédentes, dans lequel les éléments (7) présentent une perméabilité résiduelle lorsque les noyaux de commande (5) sont saturés.

**7.** Arrangement selon l'une quelconque des revendications précédentes, dans lequel les éléments (7) contiennent des métaux ferromagnétiques.

**8.** Arrangement selon l'une quelconque des revendications précédentes, dans lequel le circuit magnétique (2) enveloppe le conducteur électrique (1).

**9.** Arrangement selon l'une quelconque des revendications précédentes, dans lequel les noyaux de commande (5) se présentent sous la forme de noyaux en ferrite.

**10.** Arrangement selon la revendication 9, dans lequel les noyaux de commande (5) présentent un cadre rectangulaire et, sur au moins un côté du cadre, un enroulement de commande (6) pour la saturation du noyau de commande (5).

**11.** Arrangement selon la revendication 9, dans lequel les noyaux de commande (5) se présentent sous la forme d'une bague et, dans une zone partielle de la bague, un enroulement de commande (6) pour la saturation du noyau de commande (5).

**12.** Arrangement selon l'une quelconque des revendications précédentes, dans lequel les noyaux de commande (5) présentent un enroulement de commande (6) sur deux côtés opposés.

**13.** Arrangement selon l'une quelconque des revendications précédentes, dans lequel les noyaux de commande (5) sont disposés dans un plan commun.

14. Arrangement selon l'une quelconque des revendications 1 à 12, dans lequel les noyaux de commande (5) sont disposés à une position tournée les uns par rapport aux autres.

15. Arrangement selon l'une quelconque des revendications précédentes, dans lequel le composant sensible au champ magnétique (4) est un capteur à effet Hall.

Fig 1

Fig 2

Fig 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005024075 B4